# EUROPÄISCHE PATENTSCHRIFT

(11) **EP 4 275 085 B1**
(45) Veröffentlichungstag und Bekanntmachung des Hinweises auf die Patenterteilung: **04.02.2026**
(21) Anmeldenummer: 21836031.1
(22) Anmeldetag: 06.12.2021
(51) Int. Cl.: G02B 7/00, G02B 7/182, F16M 11/12

(54) **VORRICHTUNG ZUM POSITIONIEREN UND HALTEN ZUMINDEST EINES OPTISCHEN ELEMENTS, MESSSYSTEM**
DEVICE FOR POSITIONING AND HOLDING AT LEAST ONE OPTICAL ELEMENT, MEASUREMENT SYSTEM
DISPOSITIF DE POSITIONNEMENT ET DE MAINTIEN D'AU MOINS UN ÉLÉMENT OPTIQUE, SYSTÈME DE MESURE

(30) Priorität: 08.01.2021 DE 102021200094; 19.01.2021 DE 102021200453
(43) Veröffentlichungstag der Anmeldung: 15.11.2023
(73) Patentinhaber: Carl Zeiss SMT GmbH, 73447 Oberkochen (DE)
(72) Erfinder: GROEZINGER, Thomas, 89555 Steinheim (DE); OEZTUERK, Semih, 73614 Schorndorf (DE); LOOPSTRA, Erik, 86739 Ederheim Huernheim (DE); HAASE, Anton, 73431 Aalen (DE)
(74) Vertreter: Carl Zeiss SMT GmbH
(86) Internationale Anmeldenummer: PCT/EP2021/084412
(87) Internationale Veröffentlichungsnummer: WO 2022/148582

(56) Entgegenhaltungen:
- DE-A1- 10 330 581
- DE-C1- 19 807 119
- US-A- 4 723 075

## Beschreibung

Die vorliegende Anmeldung beansprucht die Priorität der Deutschen Patentanmeldung DE 10 2021 200 453.9, angemeldet am 8. Januar 2021.

### Hintergrund der Erfindung

Die Erfindung betrifft eine Vorrichtung zum Positionieren und Halten zumindest eines optischen Elements. Weiterhin betrifft die Erfindung ein Messsystem.

### Stand der Technik

Die Erfindung betrifft eine Vorrichtung zum Positionieren und Halten eines optischen Elements, insbesondere zur Verwendung in der Halbleiterlithografie und insbesondere zur Durchführung eines Messvorgangs. Moderne Projektionsbelichtungsanlagen für die Halbleiterlithografie machen von Projektionslicht extrem kurzer Wellenlängen, insbesondere im Bereich von mindestens 5nm und höchstens 20nm, Gebrauch. Diese sogenannten EUV (extrem ultraviolett)-Projektionsbelichtungsanlagen verwenden aufgrund der Tatsache, dass in dem genannten Wellenlängenbereich keine refraktiven optischen Elemente mit ausreichendem Transmissionsgrad zur Verfügung stehen, Spiegel zur Abbildung einer beleuchteten Reflexionsmaske, eines sogenannten Retikels, auf ein Halbleitersubstrat, welches auch als Wafer bezeichnet wird. In der Regel sind derartige Spiegel als Multilayer-Spiegel ausgeführt, bei welchen die optisch aktive Fläche aus einer Abfolge mehrerer hundert dünner Schichten mit abwechselnd unterschiedlichem Brechungsindex besteht. Bei der Herstellung derartiger Multilayer-Spiegel ist es erforderlich, eine Vermessung ihrer optischen Eigenschaften, insbesondere ihrer Reflexionseigenschaften, vorzunehmen, wozu in der Regel Vorrichtungen oder Messvorrichtungen zur Anwendung kommen, bei welchen der Spiegel in einer Vakuumkammer angeordnet und in verschiedene Raumrichtungen bewegt wird. Hierbei wurden in der Vergangenheit fett- bzw. ölfreie Lager verwendet, um eine Kontamination der optisch aktiven Fläche des Spiegels durch beispielsweise Fett- oder Ölpartikel zu vermeiden. Mit zunehmender Masse der Spiegel, insbesondere ca. 500 kg, stellt sich jedoch das Problem, dass bei der Bewegung des Spiegels auftretende erhebliche Kräfte zu einem "Fressen" der Lager führen, so dass die Bewegungsmöglichkeiten der zu vermessenden Spiegel ausgesprochen limitiert sind. Darüber hinaus führt das vorne genannte "Fressen" in der Regel zu einem Abrieb von Partikeln und damit zu der gerade nicht gewünschten Kontamination der optisch aktiven Fläche der zu vermessenden Spiegel.

Aus der Druckschrift DE 10 2015 220 817 A1 ist eine Vorrichtung zum Positionieren und Halten zumindest eines optischen Elements bekannt, wobei die Vorrichtung eine Aufnahmevorrichtung für das optische Element aufweist, wobei die Aufnahmevorrichtung auf einem Oberteil eines Luftlagers angeordnet ist, und wobei das Oberteil um eine Drehachse drehbar und in einer zur Drehachse senkrecht ausgerichteten Ebene beweglich ist.

Die Druckschrift EP 1 588 855 A1 beschreibt eine Vorrichtung zur fotoelektrischen Ausmessung einer im wesentlichen ebenen Messvorlage, mit einem fotoelektrischen Messgerät und einer nach Art eines SCARA-Roboters ("Selective Compliant Assembly Robot Arm") ausgebildete Positionierungseinrichtung, um das Messgerät zweidimensional über die auf einer Auflagefläche angeordnete Messvorlage zu führen und an definierten Messstellen der Messvorlage zu positionieren.

Die DE 10 2018 205 163 A1 beschreibt eine Messvorrichtung zur Messung von Reflexionseigenschaften eines optischen Elements für elektromagnetische Strahlung bei verschiedenen Wellenlängen im extremen ultravioletten Spektralbereich. Die Vorrichtung umfasst eine Strahlenquelle zur Bereitstellung elektromagnetischer Strahlung im extremen ultravioletten Spektralbereich und einen Monochromator zum Einstellen der Wellenlänge eines auf das optische Element gerichteten Messstrahls. Weiterhin umfasst die Vorrichtung einem Detektor zum Erfassen von an dem optischen Element reflektierter Strahlung. Darüber hinaus umfasst die Vorrichtung eine Probenhalterung oder Positioniervorrichtung. Diese hält das optische Element und ermöglicht eine Translation und Drehung des zu messenden optischen Elements in allen drei Raumrichtungen, um an unterschiedlichen Messstellen Reflektivitätsmessungen in Abhängigkeit von der Wellenlänge und vom Einfallswinkel durchführen zu können.

Eine weitere Messvorrichtung ist aus der US 4 723 075 A bekannt. Darüber hinaus sei auf die DE 198 07 119 C1 und die DE 103 30 581 A1 hingewiesen.

Es ist eine Aufgabe der Erfindung, eine verbesserte, insbesondere verschleiß- und kontaminationsarme, Vorrichtung oder Messvorrichtung bereitzustellen.

Diese Aufgabe wird gemäß den Merkmalen der unabhängigen Patentansprüche gelöst.

### Erfindungsgemäße Lösung

Erfindungsgemäß ist vorgesehen, dass die Vorrichtung folgende Komponenten aufweist: Einen ersten Grundträger, wobei der erste Grundträger um eine zu einer Auflagefläche des ersten Grundträgers senkrechte erste Drehachse drehbar ist, einen auf dem ersten Grundträger angeordneten zweiten Grundträger, wobei der zweite Grundträger um eine zur Auflagefläche des ersten Grundträgers senkrechte zweite Drehachse drehbar ist, zumindest einen auf dem zweiten Grundträger angeordneten dritten Grundträger, wobei der dritte Grundträger um eine zur Auflagefläche des ersten Grundträgers senkrechte dritte Drehachse drehbar ist, und ein auf dem dritten Grundträger angeordnetes Tragelement, wobei das Tragelement eine Haltefläche zum Halten des zumindest einen optischen Elements aufweist, wobei die Haltefläche um eine zu der Haltefläche senkrechte Rotationsachse drehbar ist. Die Drehachsen werden jeweils durch ein Drehlager, beispielsweise ein Kugellager oder Gleitlager, definiert. Der Vorteil hierbei ist, dass durch die drehbar ausgebildeten Grundträger, insbesondere die Verwendung von Drehlagern, ein Abrieb oder Verschleiß im Betrieb der Vorrichtung minimiert wird. Im Fall von geschmierten, insbesondere gefetteten oder geölten, Drehlagern erhöht sich eine Lebensdauer und eine Messgenauigkeit der Vorrichtung, insbesondere da eine Kontamination einer Vakuumkammer, in welcher die Vorrichtung im Betrieb angeordnet ist, in Folge des minimierten Abriebs oder Verschleißes verringert wird. Die Verwendung von Drehlagern hat weiterhin den weiteren Vorteil, dass sowohl Partikel, die im Drehlager entstehen, als auch geschmierte Drehlagerkomponenten deutlich besser abgeschirmt werden können als beispielsweise bei der Verwendung von Linearlagern. Weiterhin ist in geometrischer Hinsicht eine Labyrinth-Dichtung bei einem Drehlager wesentlich einfacher realisierbar als bei einer Linearachse oder einem Linearlager. Durch solch eine Labyrinth-Dichtung wird eine Kontamination der Vakuumkammer mit Partikeln und/oder Fett vermieden.

Erfindungsgemäß ist/sind das Tragelement und/oder die Haltefläche um eine zur Auflagefläche des ersten Grundträgers zumindest im Wesentlichen parallele Schwenkachse verschwenkbar. Der Vorteil hierbei ist, dass sich hierdurch die Zahl der Freiheitsgrade, in welcher das zumindest eine optische Element positionierbar oder ausrichtbar ist, erhöht.

Erfindungsgemäß ist/sind das Tragelement und/oder die Haltefläche senkrecht zur Auflagefläche des ersten Grundträgers verschiebbar. Der Vorteil hierbei ist, dass sich hierdurch die Zahl der Freiheitsgrade, in welcher das zumindest eine optische Element positionierbar oder ausrichtbar ist, erhöht.

Erfindungsgemäß ist vorgesehen, dass bezogen auf eine Referenzebene die erste, zweite und dritte Drehachse in einem Grundzustand jeweils versetzt zueinander angeordnet sind. Anders ausgedrückt: Im Grundzustand sind die Drehachsen zwar übereinander, dabei aber nicht in einer Linie angeordnet. "Grundzustand" bedeutet, dass der erste, zweite und dritte Grundträger jeweils nicht gedreht sind beziehungsweise jeweils Drehwinkel von Null Grad aufweisen. Der Vorteil hierbei ist, dass sich hierdurch die Zahl der Freiheitsgrade, in welcher das zumindest eine optische Element positionierbar oder ausrichtbar ist, erhöht. Insbesondere wird dadurch eine Positionierbarkeit oder Ausrichtbarkeit des zumindest einen optischen Elements in mehreren Freiheitsgraden, insbesondere in drei Translations- und drei Rotationsfreiheitsgraden, gewährleistet.

Gemäß einer Ausführungsform sind der erste Grundträger, der zweite Grundträger, der dritte Grundträger, das Tragelement und/oder die Haltefläche ansteuerbar ausgebildet. Der Vorteil hierbei ist, dass eine Drehung, Verschwenkung und/oder Höhenverstellung der jeweiligen Komponenten automatisch und besonders genau erfolgen kann. Vorzugsweise sind elektrische oder elektronische Antriebselemente oder Antriebsmotoren vorgesehen, welche mit dem ersten Grundträger, dem zweiten Grundträger, dem dritten Grundträger, dem Tragelement und/oder der Haltefläche wirkverbunden sind. Der erste Grundträger, der zweite Grundträger, der dritte Grundträger, das Tragelement und/oder die Haltefläche sind somit jeweils motorisch ansteuerbar.

Gemäß einer Ausführungsform weist die Vorrichtung eine Detektorhalteeinheit auf, aufweisend einen ersten Detektorgrundträger, wobei der erste Detektorgrundträger um eine zu einer Auflagefläche des ersten Detektorgrundträgers senkrechte erste Drehachse drehbar ist, einen auf dem ersten Detektorgrundträger angeordneten zweiten Detektorgrundträger, wobei der zweite Detektorgrundträger um eine zur Auflagefläche des ersten Detektorgrundträgers senkrechte zweite Drehachse drehbar ist, zumindest einen auf dem zweiten Detektorgrundträger angeordneten dritten Detektorgrundträger, wobei der dritte Detektorgrundträger um eine zur Auflagefläche des ersten Detektorgrundträgers senkrechte dritte Drehachse drehbar ist, und ein auf dem dritten Detektorgrundträger angeordnetes Detektortragelement, wobei das Detektortragelement eine Detektorhaltefläche zum Halten zumindest eines Detektors aufweist.

Gemäß einer Ausführungsform weist das zumindest eine optische Element einen beliebigen oder beliebig vorgebbaren Durchmesser und/oder eine beliebige oder beliebig vorgebbare Masse auf. Der Durchmesser ist beispielsweise und ohne hierauf beschränkt zu sein mindestens 0,01 cm, insbesondere 100 cm, und höchstens 3000 cm. Die Masse kann beispielsweise und ohne hierauf beschränkt zu sein höchstens 2000 kg sein. Der Vorteil hierbei ist, dass die Vorrichtung speziell zur Vermessung von Spiegeln ausgebildet ist oder sein kann, welche für EUV-Lithografiesysteme verwendet werden.

Gemäß einer Ausführungsform ist die Vorrichtung Bestandteil eines EUV-Reflektometers. "EUV-Reflektometer" bedeutet vorliegend eine Messvorrichtung zur Messung von Reflexionseigenschaften eines optischen Elements. Ein solches EUV-Reflektometer ist insbesondere zum Erfassen einer Reflektivität oder eines Reflexionsgrads des optischen Elements bei einer Vielzahl von Wellenlängen in einem vorgegebenen Wellenlängenbereich von extrem ultravioletter (EUV-) Strahlung konfiguriert. Insbesondere ist das EUV-Reflektometer zum Erfassen eines Reflexionsspektrums über den vorgegebenen Wellenlängenbereich ausgebildet.

Gemäß einer Ausführungsform weist die Vorrichtung zur Realisierung der jeweiligen Drehachsen jeweils ein Drehlager auf, wobei zumindest eines der Drehlager mit einem Schmiermittel geschmiert ist. Die Drehlager der Vorrichtung sind also im Betrieb der Vorrichtung mit einem Schmiermittel geschmiert, insbesondere gefettet oder geölt.

Ferner betrifft die Erfindung ein Messystem, welches eine nach einem der Ansprüche 1 bis 5 ausgebildete Vorrichtung zum Halten und Positionieren des zumindest einen optischen Elements aufweist.

Ferner ist gemäß einer Ausführungsform eine Detektorhalteeinheit zum Halten und Positionieren eines Detektors zum Erfassen einer Intensität eines von einem optischen Element reflektierten Lichtstrahls vorgesehen, aufweisend einen ersten Detektorgrundträger, wobei der erste Detektorgrundträger um eine zu einer Auflagefläche des ersten Detektorgrundträgers senkrechte erste Drehachse drehbar ist, einen auf dem ersten Detektorgrundträger angeordneten zweiten Detektorgrundträger, wobei der zweite Detektorgrundträger um eine zur Auflagefläche des ersten Detektorgrundträgers senkrechte zweite Drehachse drehbar ist, zumindest einen auf dem zweiten Detektorgrundträger angeordneten dritten Detektorgrundträger, wobei der dritte Detektorgrundträger um eine zur Auflagefläche des ersten Detektorgrundträgers senkrechte dritte Drehachse drehbar ist, und ein auf dem dritten Detektorgrundträger angeordnetes Detektortragelement, wobei das Detektortragelement eine Detektorhaltefläche zum Halten zumindest eines Detektors aufweist.

Die Detektorhalteeinheit ist vorzugsweise Bestandteil eines EUV-Reflektometers.

Im Folgenden soll die Erfindung anhand der Zeichnungen näher erläutert werden. Dazu zeigen
- Figur 1: eine vereinfachte Seitenansicht auf eine Vorrichtung zum Positionieren und Halten zumindest eines optischen Elements gemäß einem Ausführungsbeispiel,
- Figur 2: die Vorrichtung in einer beispielhaften Grundposition in einer schematischen Draufsicht,
- Figur 3: die Vorrichtung in einer beispielhaften ersten Ausrichtposition in einer schematischen Draufsicht,
- Figur 4: ein EUV-Reflektometer, welches die Vorrichtung aufweist, in einer schematischen Draufsicht,
- Figur 5: eine vereinfachte Seitenansicht auf die Vorrichtung sowie eine Detektorhalteeinheit zum Halten und Positionieren eines Detektors zum Erfassen einer Intensität eines von einem optischen Element reflektierten Lichtstrahls gemäß einem Ausführungsbeispiel.

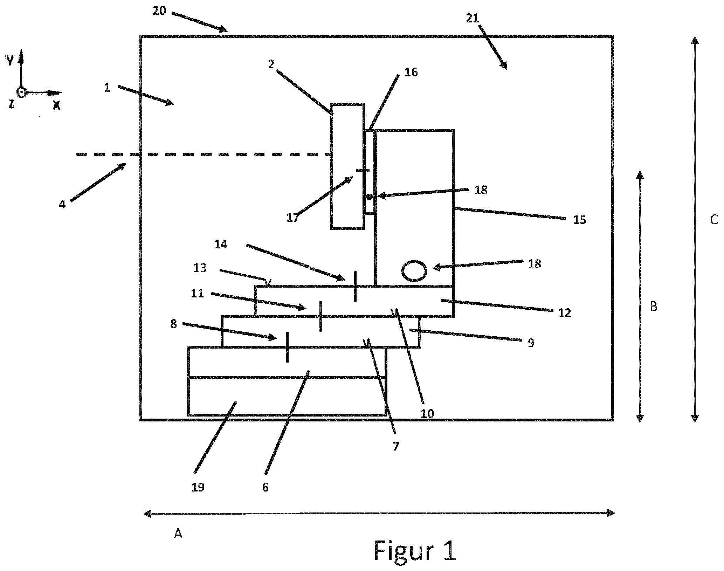

Zur besseren Veranschaulichung ist in den Figuren ein rechtshändiges kartesisches xyz- Koordinatensystem angegeben, aus dem sich die jeweilige Lagebeziehung der in den Figuren dargestellten Komponenten ergibt. Beispielsweise verläuft in Figur 1 die x-Richtung nach rechts, die y-Richtung nach oben und die z-Richtung senkrecht zur Zeichenebene aus dieser hinaus.

Figur 1 zeigt stark vereinfacht ein Ausführungsbeispiel einer Vorrichtung 1 zum Positionieren und Halten zumindest eines zu messenden optischen Elements 2, insbesondere eines Spiegels, bevorzugt eines Spiegels für ein hier nicht dargestelltes EUV-Lithografiesystem. Die Vorrichtung 1 ist vorzugsweise Bestandteil eines EUV-Reflektometers 3. "EUV-Reflektometer" bedeutet eine Messvorrichtung zur Messung von Reflexionseigenschaften des optischen Elements 2 für elektromagnetische Strahlung bei Wellenlängen im extremen ultravioletten Spektralbereich.

Die Vorrichtung 1 ist insbesondere dazu konfiguriert, das zumindest eine zu messende optische Element 2 zu halten und in Bezug auf einen, vorliegend beispielhaft eingezeichneten, Messstrahl 4, insbesondere des EUV-Reflektometers 3, in mehreren Freiheitsgraden derart zu positionieren, dass der Messstrahl 4 an einer vorgebbaren Messstelle beziehungsweise einem vorgebbaren Messort und in einem vorgebbaren Einfallswinkel beziehungsweise Einfallswinkelbereich auf einer reflektierenden Oberfläche des optischen Elements 2 auftrifft.

Die Vorrichtung 1 weist einen ersten Grundträger 6 auf, der um eine zu einer Auflagefläche 7 des ersten Grundträgers 6 senkrechte erste Drehachse 8 (Theta1-Achse) drehbar ist. Vorliegend ist die erste Drehachse in y-Richtung beziehungsweise parallel zu y-Richtung ausgerichtet. Weiterhin weist die Vorrichtung 1 einen auf dem ersten Grundträger 6 angeordneten zweiten Grundträger 9 auf, wobei der zweite Grundträger 9 um eine zur Auflagefläche 7 des ersten Grundträgers 6 oder um eine zur Auflagefläche 10 des zweiten Grundträgers 9 senkrechte zweite Drehachse 11 (Theta2-Achse) drehbar ist. Darüber hinaus weist die Vorrichtung 1 zumindest einen auf dem zweiten Grundträger 9 angeordneten dritten Grundträger 12 auf, wobei der dritte Grundträger 12 um eine zur Auflagefläche 7 des ersten Grundträgers 6 oder um eine zur Auflagefläche 13 des dritten Grundträgers senkrechte dritte Drehachse 14 (Theta3-Achse) drehbar ist.

Die erste Drehachse 8, die zweite Drehachse 11 und die dritte Drehachse 14 sind jeweils parallel zueinander ausgerichtet, gemäß dem vorliegenden Ausführungsbeispiel also jeweils in y-Richtung ausgerichtet.

Bezogen auf eine Referenzebene, vorliegend die xz-Ebene, sind die erste, zweite und dritte Drehachse 8, 11, 14 in einem Grundzustand oder einer Grundposition der Vorrichtung 1 jeweils versetzt zueinander angeordnet. Mit anderen Worten: Die Drehachsen 8, 11, 14 sind im Grundzustand oder in der Grundposition zwar in y-Richtung gesehen übereinander, aber in y-Richtung gesehen nicht in einer Linie angeordnet. "Grundzustand" oder "Grundposition" bedeutet, dass der erste, zweite und dritte Grundträger jeweils nicht gedreht sind beziehungsweise die jeweiligen Drehwinkel Theta1, Theta2 und Theta3 gleich Null Grad betragen. Dadurch wird insbesondere gewährleistet, dass mittels Drehung des zweiten Grundträgers 9 und des dritten Grundträgers 12 eine Positionierung des optischen Elements 2 in einer Ebene, vorliegend der xz-Ebene, ermöglicht wird. Vorliegend und ohne darauf beschränkt zu sein ist die Vorrichtung 1 im Grundzustand oder der Grundposition gezeigt.

Auf dem dritten Grundträger 12 ist ein Tragelement 15 angeordnet, wobei das Tragelement 15 eine Haltefläche 16 zum Halten des optischen Elements 2 aufweist, wobei die Haltefläche 16 um eine zu der Haltefläche 16 senkrechte Rotationsachse 17 (Rho-Achse) drehbar ist.

Weiterhin ist/sind das Tragelement 15 und/oder die Haltefläche 16 um eine zur Auflagefläche 7 des ersten Grundträgers 6 zumindest im Wesentlichen parallele Schwenkachse 18 (Phi-Achse) verschwenkbar. Vorliegend ist die beispielhaft eingezeichnete Schwenkachse in z-Richtung ausgerichtet, das optische Element 2 ist also in der xy-Ebene verschwenkbar.

Darüber hinaus ist/sind das Tragelement 15 und/oder die Haltefläche 16 senkrecht zur Auflagefläche 7 des ersten Grundträgers 6 oder parallel zu der ersten Drehachse 8, optional jeder der Drehachsen 8, 11, 14, verschiebbar. Dies gewährleistet eine Ausrichtung des optischen Elements 2 in y-Richtung, also insbesondere eine Höhenverstellung.

Zur Verschiebung des Tragelements 15 und/oder der Haltefläche 16 senkrecht zur Auflagefläche 7 des ersten Grundträgers 6 oder parallel zu der ersten Drehachse 8, kann das Tragelement 15 und/oder die Haltefläche 16 mittels geeigneter Mittel, beispielsweise durch ein hier nicht dargestelltes Verstellelement in Form einer höhenverstellbaren Plattform, angehoben oder abgesenkt werden. Optional ruht das Tragelement 15 und/oder die Haltefläche 16 auf zumindest drei in y-Richtung verschiebbaren Hubelementen, beispielsweise Stangen, welche jeweils beispielsweise mittels eines in der Figur nicht dargestellten Linear-Antriebes betätigt werden können, so dass sich eine Verschiebung in y-Richtung und insbesondere auch eine Kippbewegung um die Schwenkachse 18 gewährleisten lassen. Alternativ oder optional erfolgt eine Bewegung um die Schwenkachse 18 mittels einer Drehung einer Welle, welche parallel zur Schwenkachse 18 ausgerichtet ist. Vorliegend und ohne hierauf beschränkt zu sein ist die Welle ortsgleich mit der Schwenkachse 18.

Die Vorrichtung 1 ist vorliegend und ohne hierauf beschränkt zu sein auf einer Basisplatte 19 angeordnet.

Vorliegend ist die Vorrichtung 1 im Inneren einer von einem luftdicht abschließbaren Gehäuse 20 umschlossen Vakuumkammer 21 angeordnet, die mit Hilfe angeschlossener Pumpen evakuiert werden kann. Die Vakuumkammer 21 weist vorzugsweise eine Breite A von mindestens 2000 mm und höchstens 5000 mm auf. Die Vorrichtung 1 weist von der Basisplatte 19 bis zur Rotationsachse 17 oder einem die Rotationsachse 17 definierenden Drehlager eine Höhe B von mindestens 1800 mm bis höchstens 2800 mm auf. Die Vakuumkammer 21 weist vorzugsweise eine Höhe C von mindestens 2800 mm und höchstens 3800 mm auf.

Alternativ ist das EUV-Reflektometer 3 mitsamt der Vorrichtung 1 in der Vakuumkammer 21 angeordnet.

Vorzugsweise ist/sind der erste Grundträger 6, der zweite Grundträger 8, der dritte Grundträger 12, das Tragelement 15 und/oder die Haltefläche 16 ansteuerbar ausgebildet sind. Vorzugsweise ist jede der Komponenten separat mittels eines jeweilig ansteuerbaren, hier nicht dargestellten, Antriebselements, beispielsweise eines Antriebsmotors, ansteuerbar.

Das optische Element 2 kann einen beliebigen oder beliebig vorgebbaren Durchmesser und/oder eine beliebige oder beliebig vorgebbare Masse aufweisen.

Der Vorteil der Vorrichtung 1 ist, dass das zumindest eine optische Element 2 besonders genau in sechs Freiheitsgraden, also in drei Translations- und drei Rotationsfreiheitsgraden, positionierbar oder ausrichtbar ist. Vorliegend werden die Drehachsen 8, 11, 14 jeweils durch Drehlager, beispielsweise Kugellager oder Gleitlager, definiert. Mit anderen Worten: Die Vorrichtung weist Drehlager zur Realisierung der jeweiligen Drehachsen 8, 11, 14 auf. Der Vorteil bei der Verwendung von Drehlagern ist, dass bei einer Positionierung des optischen Elements 2 die Erzeugung von Kontaminationen oder Partikeln, insbesondere in Folge von Reibung, minimiert wird. Dies gewährleistet eine besonders vorteilhafte und von Kontaminationseinflüssen minimierte Messung oder Reflektivitätsmessung des optischen Elements 2. Zudem ist die durch Drehlager gebildete Vorrichtung 1 besonders einfach und kontaminationsarm in der Vakuumkammer 21 betreibbar. Vorzugsweise weist ein Drehlager eine Labyrinth-Dichtung auf. Durch solch eine Labyrinth-Dichtung wird eine Kontamination der Vakuumkammer 21 mit Partikeln und Fett vermieden. Vorzugsweise ist zumindest eines oder jedes der Drehlager mit einem Schmiermittel geschmiert, insbesondere gefettet oder geölt.

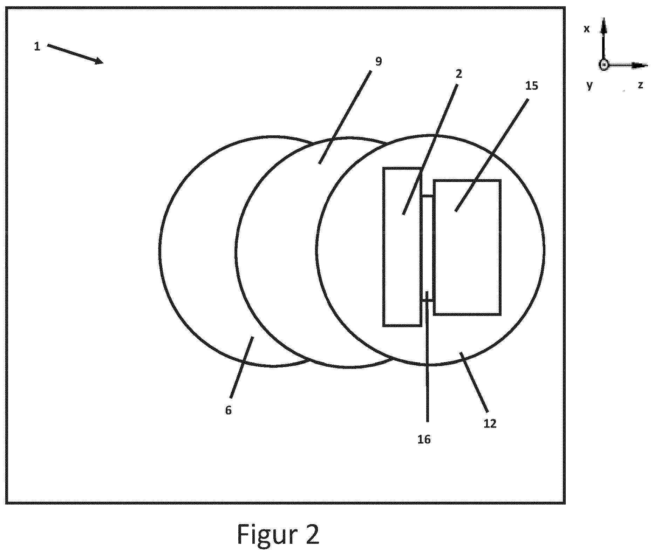

Figur 2 zeigt die Vorrichtung 1 im Grundzustand in einer schematischen Draufsicht.

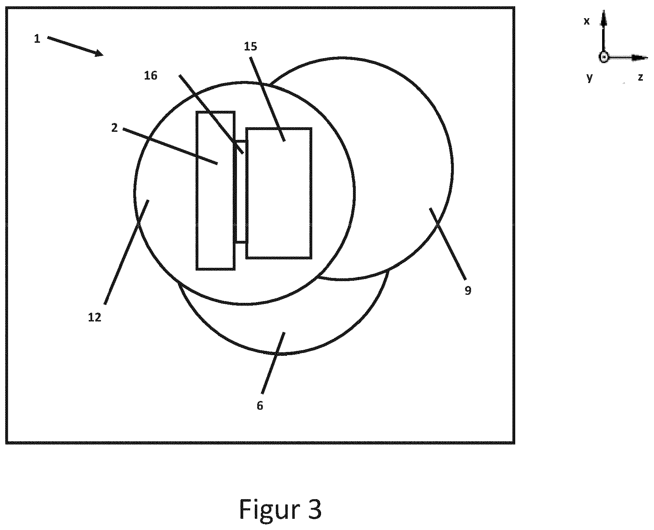

Figur 3 zeigt die Vorrichtung 1 in einer beispielhaften ersten Ausrichtposition des optischen Elements 2 in einer schematischen Draufsicht. Im Vergleich mit Figur 2 zeigt sich, dass durch Drehung des zweiten Grundträgers 8 und des dritten Grundträgers 12 das optischen Element 2 beliebig in der xz-Ebene positionierbar ist. Das optische Element ist zusätzlich in der xy-Ebene verschwenkbar, sowie in y-Richtung höhenverstellbar.

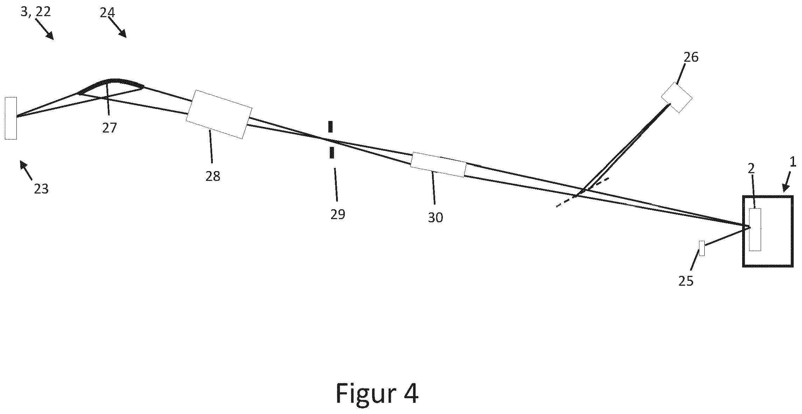

Figur 4 zeigt ein Messystem 22, insbesondere das EUV-Reflektometer 3, in einer schematischen Draufsicht. Das Messsystem 22 beziehungsweise das EUV-Reflektometer 3 umfasst eine Strahlenquelle 23 für elektromagnetische Strahlung im EUV-Spektralbereich, einen Monochromator 24 zum Einstellen beziehungsweise zur Auswahl der Wellenlänge eines auf das zumindest eine optische Element 2 gerichteten Messstrahls 4, die Vorrichtung 1 zum Halten und Positionieren des optischen Elements 2, einen Detektor 25 zum Erfassen einer Intensität eines von dem optischen Element 2 reflektierten Lichtstrahls und einen Referenzdetektor 26 zum Erfassen einer Intensität des auf das optische Element 2 gerichteten Messstrahls 4.

Die Strahlenquelle 23 dieses Ausführungsbeispiels umfasst einen gepulsten Laser, beispielsweise einen Nd:YAG-Laser, dessen Laserstrahl mittels einer nicht dargestellten Fokussierungsoptik auf ein geeignetes Target-Material, beispielsweise ein Gold-Target, fokussiert wird. Der Laserstrahl erzeugt bei der Oberfläche des Target-Materials ein Plasma, welches im EUV-Bereich ein quasikontinuierliches Spektrum elektromagnetischer Strahlung emittiert. Das Plasma stellt somit einen Quell- oder Emissionsfleck für EUV-Strahlung dar. Ein Teil der von dem Quellfleck emittierten EUV-Strahlung durchtritt als Messstrahl 4 eine hier nicht dargestellte Eingangsblende als Eintrittsöffnung des Monochromators 24. Der Monochromator 24 weist weiterhin ein im Strahlengang des Messtrahls 4 angeordnetes erstes Reflexionselement 27, ein im Strahlengang nach dem ersten Reflexionselement 27 angeordnetes zweites Reflexionselement 28, einen im Strahlengang nach dem zweiten Reflexionselement 28 angeordneten Austrittsspalt 29 und ein im Strahlengang nach dem Austrittsspalt 29 angeordnetes drittes Reflexionselement 30 auf. Der Strahlengang des Messstrahls 4 verläuft vorliegend von der Strahlungsquelle 23 bis zum Detektor 25. Das zweite Reflexionselement 28 ist vorzugsweise als planes, optional als sphärisches, Gitter ausgebildet.

Die Verwendung der Vorrichtung 1 ist nicht auf das vorliegend dargestellte Messystem 22 beschränkt. Vielmehr ist die Vorrichtung 1 auch mit anderen Messsystemen oder EUV-Reflektometern, insbesondere mit anderen Strahlenquellen und/oder Beamlines beziehungsweise Beamline-Designs, wie beispielsweise in DE 10 2018 205 163 A1 beschrieben, verwendbar.

Alternativ ist das EUV-Reflektometer 3 mitsamt der Vorrichtung 1 in der Vakuumkammer 21 angeordnet.

Optional sind mehrere optische Elemente 2 auf dem Tragelement 15 angeordnet. Das optische Element 2 kann optional ein Facettenspiegel, insbesondere für die Verwendung in einem EUV-Lithografiesystem, sein.

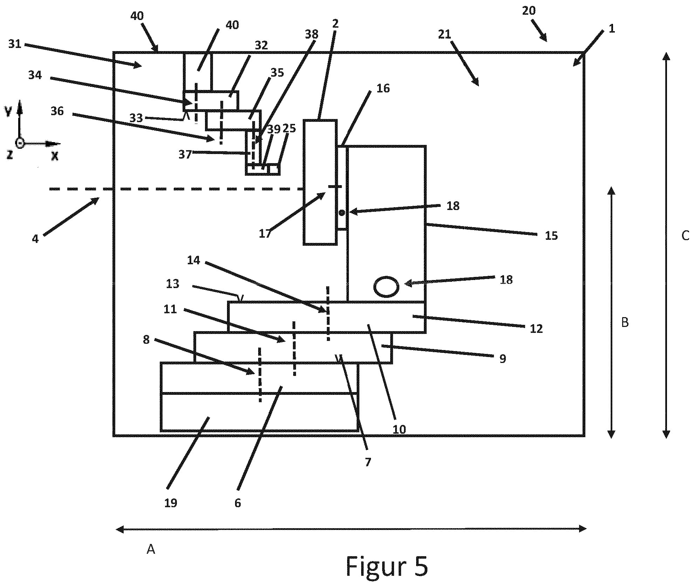

Figur 5 zeigt die Vorrichtung 1 aus Figur 1, wobei gemäß dem vorliegenden Ausführungsbeispiel zusätzlich eine Detektorhalteeinheit 31 zum Halten und Positionieren des Detektors 25 zum Erfassen einer Intensität eines von dem optischen Element 2 reflektierten Lichtstrahls dargestellt ist.

Die Detektorhalteeinheit 31 weist einen ersten Detektorgrundträger 32 auf, wobei der erste Detektorgrundträger 32 um eine zu einer Auflagefläche 33 des ersten Detektorgrundträgers 32 senkrechte erste Drehachse 34 drehbar ist, einen auf dem ersten Detektorgrundträger 32 angeordneten zweiten Detektorgrundträger 35, wobei der zweite Detektorgrundträger 35 um eine zur Auflagefläche 33 des ersten Detektorgrundträgers 32 senkrechte zweite Drehachse 36 drehbar ist, zumindest einen auf dem zweiten Detektorgrundträger 35 angeordneten dritten Detektorgrundträger 37, wobei der dritte Detektorgrundträger 37 um eine zur Auflagefläche 33 des ersten Detektorgrundträgers 32 senkrechte dritte Drehachse 38 drehbar ist, und ein auf dem dritten Detektorgrundträger 37 angeordnetes oder mit dem dritten Detektorgrundträger 37 wirkverbundenes Detektortragelement 39, wobei das Detektortragelement 39 eine Detektorhaltefläche zum Halten des Detektors 25 aufweist. Optional sind an der Detektorhaltefläche 39 mehrere Detektoren angeordnet oder anordenbar.

Der dritte Detektorgrundträger 37, das Detektortragelement 39 und/oder die Detektorhaltefläche ist/sind optional senkrecht zur Auflagefläche 33 des ersten Detektorgrundträgers 32, vorliegend also in y-Richtung, verschiebbar. Dies gewährleistet, dass der Detektor 25 in y-Richtung vorgebbar positionierbar ist.

Optional ist/sind das Detektortragelement 39 und/oder die Detektorhaltefläche um eine zu der Detektorhaltefläche senkrechte und hier nicht dargestellte Detektorrotationsachse drehbar.

Die Detektorhalteeinheit 31 ist vorzugsweise an einer Oberseite 40 oder Deckenseite der Vakuumkammer 21 angeordnet.

Durch die Detektorhalteeinheit 31 ist der Detektor 25 vorliegend beliebig in x-, z- und y-Richtung verfahrbar. Dies gewährleistet eine besonders genaue Ausrichtbarkeit des Detektors 25 auf einen durch das zumindest eine optische Element 25 reflektierten Lichtstrahls. Optional ist der Detektor 25 verschwenkbar und/oder rotierbar.

Die Verwendung der Detektorhalteeinheit 31 nicht auf die vorliegend dargestellte Vorrichtung 1 beschränkt. Vielmehr ist die Detektorhalteeinheit 31 auch mit anderen oder anders ausgestalteten Vorrichtungen zum Positionieren und Halten zumindest eines optischen Elements verwendbar. Die Detektorhalteeinheit 31 ist vorzugsweise Bestandteil eines EUV-Reflektometers 3.

## Patentansprüche

1. Vorrichtung (1) zum Positionieren und Halten zumindest eines optischen Elements (2), aufweisend
einen ersten Grundträger (6), wobei der erste Grundträger (6) um eine zu einer Auflagefläche (7) des ersten Grundträgers (6) senkrechte erste Drehachse (8) drehbar ist,
einen auf dem ersten Grundträger (6) angeordneten zweiten Grundträger (9), wobei der zweite Grundträger (9) um eine zur Auflagefläche (7) des ersten Grundträgers (6) senkrechte zweite Drehachse (11) drehbar ist,
zumindest einen auf dem zweiten Grundträger (9) angeordneten dritten Grundträger (12), wobei der dritte Grundträger (12) um eine zur Auflagefläche (7) des ersten Grundträgers (6) senkrechte dritte Drehachse (14) drehbar ist, und
ein auf dem dritten Grundträger (12) angeordnetes Tragelement (15), wobei das Tragelement (15) eine Haltefläche (16) zum Halten des optischen Elements (2) aufweist, und wobei bezogen auf eine vorgebbare Referenzebene die erste Drehachse (8), zweite Drehachse (11) und dritte Drehachse (14) in einem Grundzustand der Vorrichtung (1) jeweils versetzt zueinander angeordnet sind, **dadurch gekennzeichnet,**
**dass** die Haltefläche (16) um eine zu der Haltefläche (16) senkrechte Rotationsachse (17) drehbar ist, wobei das Tragelement (15) und/oder die Haltefläche (16) um eine zur Auflagefläche (7) des ersten Grundträgers (6) zumindest im Wesentlichen parallele Schwenkachse (18) verschwenkbar ist/sind, und
**dass** das Tragelement (15) und/oder die Haltefläche (16) senkrecht zur Auflagefläche (7) des ersten Grundträgers (6) verschiebbar ist/sind.

2. Vorrichtung nach Anspruch 1, **dadurch gekennzeichnet, dass** der erste Grundträger (6), der zweite Grundträger (9), der dritte Grundträger (12), das Tragelement (15) und/oder die Haltefläche (16) ansteuerbar ausgebildet sind.

3. Vorrichtung nach einem der vorhergehenden Ansprüche, **gekennzeichnet durch** eine Detektorhalteeinheit (31), aufweisend einen ersten Detektorgrundträger (32), wobei der erste Detektorgrundträger (32) um eine zu einer Auflagefläche (33) des ersten Detektorgrundträgers (32) senkrechte erste Drehachse (34) drehbar ist, einen auf dem ersten Detektorgrundträger (32) angeordneten zweiten Detektorgrundträger (35), wobei der zweite Detektorgrundträger (35) um eine zur Auflagefläche (33) des ersten Detektorgrundträgers (32) senkrechte zweite Drehachse (36) drehbar ist, zumindest einen auf dem zweiten Detektorgrundträger (35) angeordneten dritten Detektorgrundträger (37), wobei der dritte Detektorgrundträger (37) um eine zur Auflagefläche (33) des ersten Detektorgrundträgers (32) senkrechte dritte Drehachse (38) drehbar ist, und ein auf dem dritten Detektorgrundträger (37) angeordnetes Detektortragelement (39), wobei das Detektortragelement (39) eine Detektorhaltefläche zum Halten zumindest eines Detektors (25) aufweist.

4. Vorrichtung nach einem der vorhergehenden Ansprüche, **dadurch gekennzeichnet, dass** die Vorrichtung (1) Bestandteil eines EUV-Reflektometers (3) ist.

5. Vorrichtung nach einem der vorhergehenden Ansprüche, **dadurch gekennzeichnet, dass** die Vorrichtung (1) zur Realisierung der jeweiligen Drehachsen (8, 11, 14) jeweils ein Drehlager aufweist, wobei zumindest eines der Drehlager mit einem Schmiermittel geschmiert ist.

6. Messsystem (22), aufweisend eine Strahlenquelle (23) für elektromagnetische Strahlung im EUV-Spektralbereich, einen Monochromator (24) zum Einstellen oder Auswählen einer Wellenlänge eines auf zumindest ein optisches Element (2) gerichteten Messstrahls (4), zumindest einen Detektor (25) zum Erfassen einer Intensität eines von dem optischen Element (2) reflektierten Lichtstrahls und einen Referenzdetektor (26) zum Erfassen einer Intensität des auf das optische Element (2) gerichteten Messstrahls (4), **gekennzeichnet durch** eine nach einem der Ansprüche 1 bis 5 ausgebildeten Vorrichtung (1) zum Halten und Positionieren des zumindest einen optischen Elements (2).

## Claims

1. Device (1) for positioning and holding at least one optical element (2), having
a first main carrier (6), the first main carrier (6) being rotatable about a first axis of rotation (8) perpendicular to a bearing surface (7) of the first main carrier (6),
a second main carrier (9) arranged on the first main carrier (6), the second main carrier (9) being rotatable about a second axis of rotation (11) perpendicular to the bearing surface (7) of the first main carrier (6),
at least one third main carrier (12) arranged on the second main carrier (9), the third main carrier (12) being rotatable about a third axis of rotation (14) perpendicular to the bearing surface (7) of the first main carrier (6), and
a supporting element (15) arranged on the third main carrier (12), the supporting element (15) having a holding surface (16) for holding the optical element (2), and the first axis of rotation (8), second axis of rotation (11) and third axis of rotation (14) each being arranged offset to one another with respect to a specifiable reference plane in a basic state of the device (1), **characterized**
**in that** the holding surface (16) is rotatable about an axis of rotation (17) perpendicular to the holding surface (16), wherein the supporting element (15) and/or the holding surface (16) is/are pivotable about a pivot axis (18) which is at least substantially parallel to the bearing surface (7) of the first main carrier (6), and in that the supporting element (15) and/or the holding surface (16) is/are displaceable perpendicularly to the bearing surface (7) of the first main carrier (6).

2. Device according to Claim 1, **characterized in that** the first main carrier (6), the second main carrier (9), the third main carrier (12), the supporting element (15) and/or the holding surface (16) are designed to be controllable.

3. Device according to either of the preceding claims, **characterized by** a detector holding unit (31) having a first detector main carrier (32), the first detector main carrier (32) being rotatable about a first axis of rotation (34) perpendicular to a bearing surface (33) of the first detector main carrier (32), a second detector main carrier (35) arranged on the first detector main carrier (32), the second detector main carrier (35) being rotatable about a second axis of rotation (36) perpendicular to the bearing surface (33) of the first detector main carrier (32), at least one third detector main carrier (37) arranged on the second detector main carrier (35), the third detector main carrier (37) being rotatable about a third axis of rotation (38) perpendicular to the bearing surface (33) of the first detector main carrier (32), and a detector supporting element (39) arranged on the third detector main carrier (37), the detector supporting element (39) having a detector holding surface for holding at least one detector (25).

4. Device according to any one of the preceding claims, **characterized in that** the device (1) is part of an EUV reflectometer (3).

5. Device according to any one of the preceding claims, **characterized in that** the device (1) has respective pivot bearings for realizing the respective axes of rotation (8, 11, 14), at least one of the pivot bearings being lubricated with a lubricant.

6. Measurement system (22), having a radiation source (23) for electromagnetic radiation in the EUV spectral range, a monochromator (24) for setting or selecting a wavelength of a measurement beam (4) directed onto at least one optical element (2), at least one detector (25) for detecting an intensity of a light beam reflected by the optical element (2) and a reference detector (26) for detecting an intensity of the measurement beam (4) directed onto the optical element (2), **characterized by** a device (1) configured according to any one of Claims 1 to 5 for holding and positioning the at least one optical element (2).

## Revendications

1. Dispositif (1) de positionnement et de maintien d'au moins un élément optique (2), comprenant
un premier support de base (6), le premier support de base (6) pouvant tourner autour d'un premier axe de rotation (8) perpendiculaire à une surface d'appui (7) du premier support de base (6),
un deuxième support de base (9), disposé sur le premier support de base (6), le deuxième support de base (9) pouvant tourner autour d'un deuxième axe de rotation (11) perpendiculaire à la surface d'appui (7) du premier support de base (6),
au moins un troisième support de base (12), disposé sur le deuxième support de base (9), le troisième support de base (12) pouvant tourner autour d'un troisième axe de rotation (14) perpendiculaire à la surface d'appui (7) du premier support de base (6), et
un élément de support (15), disposé sur le troisième support de base (12), l'élément de support (15) ayant une surface de maintien (16) pour le maintien de l'élément optique (2), et le premier axe de rotation (8), le deuxième axe de rotation (11) et le troisième axe de rotation (14), par rapport à un plan de référence prédéfinissable, étant respectivement disposés de manière décalée l'un par rapport à l'autre lorsque le dispositif (1) est dans un état de base, **caractérisé en ce que**
la surface de maintien (16) peut tourner autour d'un axe de rotation (17) perpendiculaire à la surface de maintien (16), l'élément de support (15) et/ou la surface de maintien (16) est/sont pivotants autour d'un axe de pivotement (18) au moins sensiblement parallèle à la surface d'appui (7) du premier support de base (6), et **en ce que** l'élément de support (15) et/ou la surface de maintien (16) est/sont déplaçables perpendiculairement à la surface d'appui (7) du premier support de base (6).

2. Dispositif selon la revendication 1, **caractérisé en ce que** le premier support de base (6), le deuxième support de base (9), le troisième support de base (12), l'élément de support (15) et/ou la surface de maintien (16) sont conçus pour être commandables.

3. Dispositif selon l'une des revendications précédentes, **caractérisé par** une unité de maintien de détecteur (31), comprenant un premier support de base de détecteur (32), le premier support de base de détecteur (32) pouvant tourner autour d'un premier axe de rotation (34) perpendiculaire à une surface d'appui (33) du premier support de base de détecteur (32), un deuxième support de base de détecteur (35) disposé sur le premier support de base de détecteur (32), le deuxième support de base de détecteur (35) pouvant tourner autour d'un deuxième axe de rotation (36) perpendiculaire à la surface d'appui (33) du premier support de base de détecteur (32), au moins un troisième support de base de détecteur (37) disposé sur le deuxième support de base de détecteur (35), le troisième support de base de détecteur (37) pouvant tourner autour d'un troisième axe de rotation (38) perpendiculaire à la surface d'appui (33) du premier support de base de détecteur (32), et un élément de support de détecteur (39) disposé sur le troisième support de base de détecteur (37), l'élément de support de détecteur (39) ayant une surface de maintien de détecteur pour le maintien d'au moins un détecteur (25).

4. Dispositif selon l'une des revendications précédentes, **caractérisé en ce que** le dispositif (1) fait partie intégrante d'un réflectomètre EUV (3).

5. Dispositif selon l'une des revendications précédentes, **caractérisé en ce que** le dispositif (1) comprend respectivement un palier de pivotement pour la réalisation des axes de rotation respectifs (8, 11, 14), au moins l'un des paliers de pivotement étant lubrifié avec un lubrifiant.

6. Système de mesure (22), comprenant une source de rayonnement (23) destinée à un rayonnement électromagnétique dans le domaine spectral EUV, un monochromateur (24) pour régler ou sélectionner une longueur d'onde d'un faisceau de mesure (4) dirigé vers au moins un élément optique (2), au moins un détecteur (25) pour la détection d'une intensité d'un faisceau lumineux réfléchi par l'élément optique (2) et un détecteur de référence (26) pour la détection d'une intensité du faisceau de mesure (4) dirigé vers l'élément optique (2), **caractérisé par** un dispositif (1) selon l'une des revendications 1 à 5 pour le maintien et le positionnement dudit au moins un élément optique (2).
